Europäisches Patentamt

European Patent Office

Office européen des brevets

(19)

(11) Publication number: **0 124 960**
**A2**

## (12) EUROPEAN PATENT APPLICATION

(21) Application number: **84300995.2**

(22) Date of filing: **16.02.84**

(51) Int. Cl.³: **H 01 L 21/28**
**H 01 L 21/90**

(30) Priority: **05.05.83 GB 8312280**
**26.10.83 GB 8328552**

(43) Date of publication of application:
**14.11.84 Bulletin 84/46**

(84) Designated Contracting States:
**DE FR IT NL**

(71) Applicant: **STANDARD TELEPHONES AND CABLES**
**PUBLIC LIMITED COMPANY**
**190 Strand**
**London, WC2R 1DU(GB)**

(72) Inventor: **Scovell, Peter Denis**
**14, Staplecroft**
**Chelmsford Essex(GB)**

(72) Inventor: **Rosser, Paul John**
**120, Carters Mead Potter Street**
**Harlow Essex(GB)**

(72) Inventor: **Tomkins, Gary John**
**111 Joyners Field**
**Harlow Essex(GB)**

(74) Representative: **Dennis, Mark Charles**
**STC Patent Department Edinburgh Way**
**Harlow Essex CM20 2SH(GB)**

(54) Semiconductor devices comprising silicides.

(57) Polysilicon elements of integrated circuits, for example gates (24) or interconnects, are provided with metallic silicide layers (26) in order to take advantage of the lower resistivity thereof. The polysilicon elements are defined on an oxide layer (23) disposed on a silicon substrate (20) before polysilicon metallisation. After polysilicon metallisation the metal and polysilicon are caused to interdiffuse to form silicide layers (26) covering the polysilicon elements (24).

EP 0 124 960 A2

SEMICONDUCTOR DEVICES

This invention relates to semiconductor devices and the manufacture thereof and, in particular, to semiconductor processing employing silicides.

Polysilicon has conventionally been employed for gates and interconnections in integrated circuits. However, for small geometry, high speed integrated circuits it is desirable to use alternative materials with lower resistivity, such as silicide materials. The resistivity of polysilicon is high ($1000\mu\Omega$cm) and roughly fifty times larger than some silicides, for example titanium disilicide has a resistivity of $20\,\mu\Omega$cm, and thus interconnections of polysilicon are extremely resistive in fine-line circuits. The propagational delay of electrical signals in such interconnect lines is a function of the product of the lumped capacitance and resistance of the interconnect line. As devices sizes are scaled down to achieve higher packing densities and speeds, this delay becomes dominated by the resistive component and thus new materials must be used. Silicides comprise such alternative materials which can be entirely compatible with the other components of the manufacturing process. Provided that the introduction of the material does not significantly perturb the existing process, the advantage of the new material can also be exploited in present day technologies.

- 2 - 0124960

A process has been developed whereby the silicide is formed by interdiffusing a layer of metal (tungsten, molybdenum, titanium, tantalum, etc.) with a sheet of doped polysilicon used to form the conventional gate and interconnects. This heterogeneous layer is then etched to form the gate and interconnects of the device. However, because the silicide overlying the doped polysilicon etches at different rates from the polysilicon, some undesirable undercutting at the gate occurs.

An alternative process has been developed to silicide the gate and diffused regions, however this is a complex process.

The undercutting problems of the first mentioned process and the complexity of the second represent considerable barriers to the implementation of silicide into an existing process.

According to the present invention there is provided a method of manufacturing semiconductor devices including the steps of defining at least one polysilicon element on an oxidised surface of a silicon substrate, metallising the at least one defined polysilicon element, including sidewalls thereof, and causing the interdiffusion of the metal and the polysilicon whereby to form a metallic silicide layer extending over the at least one defined polysilicon element and up to the said oxidised surface on which the at least one defined polysilicon element is disposed.

An embodiment of the present invention will now be described with reference to the accompanying drawings, in which·-

Figs. 1a to c represent in schematic cross-section successive stages in the first-mentioned known process[

Figs. 2a to c represent in schematic cross-section successive stages in the second-mentioned known process, and

Figs. 3a to c represent in schematic cross-section successive stages in a method according to the present invention.

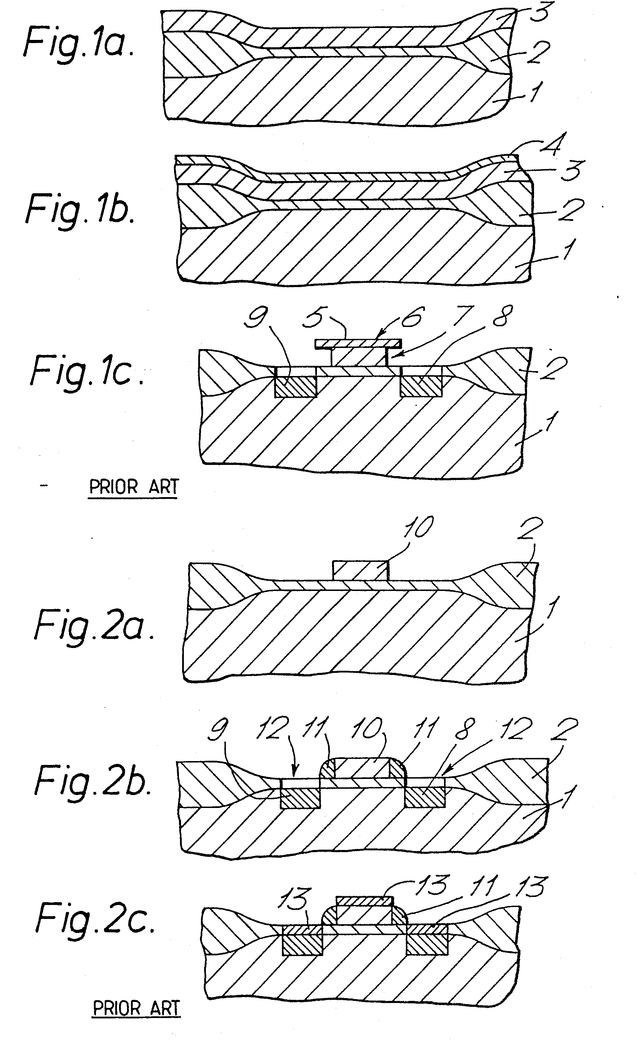

The known process shown in Figs. 1a to c comprises the following steps.   On a silicon substrate 1, an oxide layer 2, which is thin in the area where source, drain and gate regions of the device are to be formed, is provided by conventional means.   A layer of doped polycrystalline silicon (polysilicon) 3 is provided over the oxide 2 (Fig.1a).   A metal layer 4 (Fig. 1b) of, for example, tungsten, molybdenum, titanium or tantalum, is deposited on the polysilicon layer 3.   A metallic silicide layer (Fig. 1c) is formed by interdiffusing layers 3 and 4.   The structure is then etched to form the gate 6 of the device and interconnects (not shown) and, because the silicide 5 etches at a different rate from the doped polysilicon 3, undercutting as at 7 occurs.   The source 8 and drain 9 regions are next defined and implanted or diffused, and the process continues with the conventional oxidation step (intermediate oxide) (not shown), the oxidation at the silicide layer of the gate 6 relying on the diffusion of silicon from the underlying polysilicon to feed the oxidation process.   The commercial process which employs this procedure is termed the POLYCIDE process.   Adoption of the POLYCIDE process results in few changes when compared with the conventional polysilicon process, except that it introduces difficulties in etching the heterogeneous structure.

In the other known process illustrated in Figs. 2a to c and termed the SALICIDE process, the gate, interconnect, and diffused regions are silicided.   In this process a polysilicon gate 10 is defined conventionally upon oxide layer 2 on substrate 1.   A layer of CVD (chemical vapour deposited) oxide is deposited over the gate 10 and interconnects (not shown) and this oxide is etched anisotropically to leave side wall spacers 11 of oxide adjacent the gate 10.   This etching serves also to open windows 12, via which the source and drain regions 8 and 9 are formed conventionally, and to remove any oxide in the contact areas and on the polysilicon 10. A layer of metal, for example titanium, tantalum etc., is then deposited over the substrate surface and metallic silicide 13 formed by interdiffusing in a furnace the metal of the layer and the silicon. Only in the areas of exposed silicon can the silicide form and no change occurs where the metal is deposited over oxide. The residual (unreacted) metal is then etched away preferentially to leave the silicide 13 in the diffused, and gate interconnect areas as illustrated in Fig. 2c, together with other interconnect areas, not shown. This method is called SALICIDE (self-aligned silicide), the silicide being self-aligned to the exposed silicon. Processing continues with the conventional oxidation step etc. The oxide sidewall spacers 11 introduce complexities with regard to processing, but they are essential to avoid gate to source/drain short circuits.

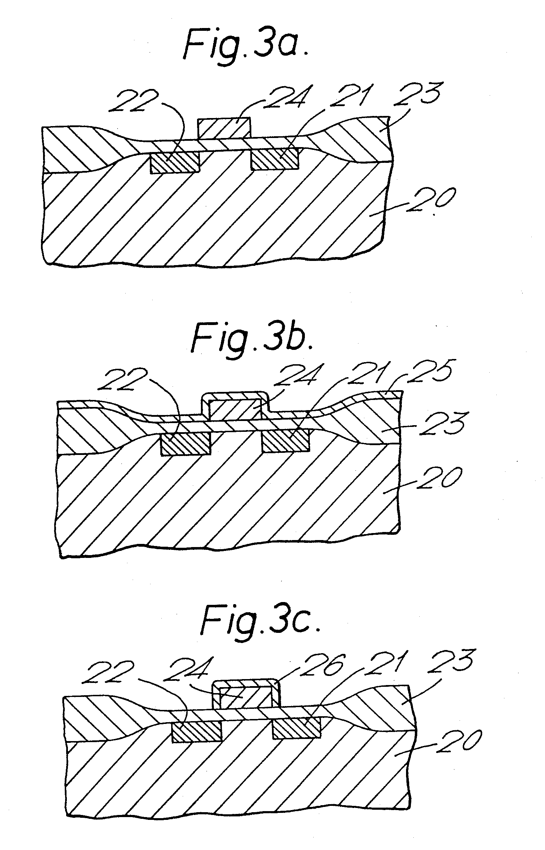

An embodiment of the present invention is illustrated in Figs. 3a to c. Fig. 3a shows a silicon substrate 20 in which source and drain regions 21 and 22 have been provided by suitable processing, for example selective diffusion or implantation. An oxide layer 23 extends over the entire surface of the substrate 20 and as illustrated is thinner in the source, drain, gate region due to the processing involved. A layer of doped polycrystalline silicon (polysilicon) is provided over the oxide 23 and etched to define a polysilicon gate 24 aligned with the source and drain regions 21 and 22, together with interconnects (not shown). A layer of metal 25 (Fig. 3b), for example, titanium, tungsten, tantalum, molybdenum etc., is then deposited over the polysilicon gate 24, interconnects and the exposed oxide 23. During a subsequent annealing process the metal overlying the polysilicon gate 24 and polysilicon interconnects becomes interdiffused therewith to form a metallic silicide, whereas there is no reaction between the metal and any directly underlying oxide. The residual (unreacted) metal is etched away to leave a metallic silicide 26 (Fig. 3c) over the gate 24 and around its sidewalls and similarly over and around the interconnects. Processing continues with the conventional intermediate oxidation using the underlying polysilicon as a source of silicon to feed the oxidation process at the gate. The etchant employed to define the polysilicon gate 24 and interconnects must be sufficiently selective to leave the oxide 23 over the diffused regions 21 and 22, otherwise silicides would form in these regions leading to gate to source/drain short circuits.

A suitable annealing process is a transient (pulse) process which comprises raising the temperature of the thus processed silicon substrate to $800^{\circ}C$ within 10 seconds and then allowing it to cool naturally. This annealing is performed in a chamber which is purged by nitrogen and the oxygen and water concentrations should not exceed 2 rpm. Such annealing may be performed using a commercial halogen lamp annealing equipment such as "Heatpulse" as supplied by A.G. Associates of Palo Alto, Ca., United States of America.

In the case of titanium we have found that it is necessary to interdiffuse the titanium and polysilicon using such a pulse annealing technique since titanium has such a strong affinity for oxygen and normal furnace annealing results in oxidation of the metal before the silicide is formed. Even with use of an inert gas (nitrogen) in a normal furnace, air trapped between wafers during loading in the furnace and contamination of the inert gas with small quantities of oxygen and water leads to significant oxidation.

Our United Kingdom Patent Application No. 8203242 (Serial No. 2114809) relates to the formation of silicides from titanium and silicon which are deposited as a plurality of alternate layers, or are co-sputtered, and are pulse annealed. The present application, however, is concerned with a process for forming a silicide layer, by interdiffusing a single separate metallic layer, preferably titanium, overlying a defined polysilicon element, which can be readily implemented into an existing manufacturing process.

The proposed process is similar to the POLYCIDE process but differs therefrom in that the gate and interconnects are defined before the metal deposition step and in that no undercutting results. The proposed process can be implemented with conventional processing technology and does not disturb the overall conventional polysilicon process significantly, whilst resulting in low interconnect resitance values and retaining the oxidisability of the resulting silicide composite.

CLAIMS :-

1. A method of manufacturing semiconductor devices characterised in that the steps of defining at least one polysilicon element (24) on an oxidised surface (23) of a silicon substrate (20), metallising (25) the at least one defined polysilicon element (24) including sidewalls thereof, and causing interdiffusion of the metal (25) and the polysilicon (24) whereby to form a metallic silicide layer (26) extending over the at least one defined polysilicon element (24) and up to the said oxidised surface (23) on which the at least one defined polysilicon element (24) is disposed.

2. A method as claimed in claim 1, characterised in that the at least one polysilicon element (24) comprises a polysilicon gate and/or an interconnection.

3. A method as claimed in claim 1 or claim 2, characterised in that those portions of the oxidised surface (23) of the silicon substrate surrounding the at least one polysilicon element (24) are metallised during the metallisation step, and wherein the metal is removed from said portions after the interdiffusion step.

4. A method as claimed in any one of the preceding claims characterised in that the step of defining source and drain regions (21, 22) in the substrate (20) prior to definition of the at least one polysilicon element (24).

5. A method as claimed in any one of the preceding claims characterised in that the metal is titanium.

6. A method as claimed in claim 5, characterised in that the interdiffusion is achieved by pulse annealing in an inert atmosphere.

Fig.1a.

Fig.1b.

Fig.1c.

PRIOR ART

Fig.2a.

Fig.2b.

Fig.2c.

PRIOR ART

2/2

## Fig.3a.

## Fig.3b.

## Fig.3c.